# EUROPÄISCHE PATENTANMELDUNG

(11) **EP 4 815 290 A1**
(43) Veröffentlichungstag der Anmeldung: **30.09.2026**
(21) Anmeldenummer: 26165920.5
(22) Anmeldetag: 18.03.2026
(51) Int. Cl.: H02M 7/5395, H02M 7/00, H02M 1/44, H02G 5/00, H05K 7/14, H10D 84/01, H10D 84/00

(54) **N-KOMPONENTEN-LEISTUNGSELEKTRONIKSCHALTUNG MIT EINEM GEMEINSAMEN ZWISCHENKREISKONDENSATOR**

(30) Priorität: 26.03.2025 DE 102025111665
(71) Anmelder: Volkswagen Aktiengesellschaft, 38440 Wolfsburg (DE)
(72) Erfinder: Othmani, Karim, 38440 Wolfsburg (DE); Sommer, Christian, 38440 Wolfsburg (DE)

(57) **Zusammenfassung**

Die Erfindung betrifft Leistungselektronikschaltungen, insbesondere von Fahrzeugen, insbesondere von Fahrzeugen mit mindestens einer elektrischen Antriebmaschine, bei denen die Leistungselektronikmodule (10, 10-i) von mindestens drei verschiedenen Funktionskomponenten (20, 20-i) in einem Zwischenkreis (100) energetisch auf einer Gleichspannungsebene miteinander gekoppelt sind. Vorgeschlagen wird eine Leistungselektronikschaltung (1) umfassend eine Mehrzahl N von Leistungselektronikmodulen (10, 10-i) von N Funktionskomponenten, die in einem Zwischenkreis (100) energetisch auf einer Gleichspannungsebene miteinander gekoppelt sind, wobei die Mehrzahl N von Leistungselektronikmodulen (10, 10-i) alle gemeinsam direkt an einen Zwischenkreiskondensator (110) angeschlossen sind.

## Beschreibung

Die Erfindung betrifft Leistungselektronikschaltungen, insbesondere von Fahrzeugen, insbesondere von Fahrzeugen mit mindestens einer einem elektrischen Antriebmaschine, bei denen mindestens die Leistungselektronikmodule von mindestens zwei verschiedene Funktionskomponenten in einem Zwischenkreis energetisch auf einer Gleichspannungsebene miteinander gekoppelt sind.

In einem Fahrzeug, insbesondere einem Fahrzeug mit einer elektrischen Antriebsmaschine existieren eine Mehrzahl von verschiedenen Funktionen erfüllende Komponenten. Diese umfassen neben einem Traktionswechselrichter, um für eine elektrische Maschine eine mehrphasige Bestromung beispielsweise eines Stators zu gewährleiten, beispielsweise einen Niedervolt-Gleichspanungs-Gleichspannungs-Wandler (DC/DC-Wandler), um eine Niederspannungsnetz, beispielsweise ein Bordnetz zu betreiben, eine EMV-Filterschaltung für eine Batterie, insbesondere eine Traktionsbatterie, wobei EMV für elektromagnetische Verträglichkeit steht. Die weitere Funktionskomponenten können auch einen Hochvolt-Gleichspanungs-Gleichspannungs-Wandler, eine Filter- und/oder Stromstellerschaltung für einen Rotorstrom einer fremderregten Synchronmaschine (FSM) oder einen Klimakompressor, einen Gleichspannungs-Wechselspannungs-Wandler für ein Betreiben von Wechselspannungs-Verbrauchern oder zum Ausbilden eines in das Fahrzeug integrierten Ladegeräts etc. umfassen.

Um die energetische Kopplung auf Gleichspannungsebene des Zwischenkreises zu gewährleisten, weist in der Regel jedes Leistungselektronikmodul einer Funktionskomponente im Stand der Technik einen Kondensator auf, der zwischen den Anschlusselementen der Leistungselektronikmodul elektrisch leitend verbunden ist.

US 2020/328027 A1 beschreibt ein System zum Verhindern der Überhitzung eines Zwischenkreiskondensators in einem Elektrofahrzeug, das Folgendes umfasst: einen Zwischenkreiskondensator mit einer positiven und einer negativen Elektrode; ein Paar Sammelschienen, wobei die positive Sammelschiene mit der positiven Elektrode des Zwischenkreiskondensators verbunden ist und die negative Sammelschiene mit der negativen Elektrode des Zwischenkreiskondensators verbunden ist; eine dielektrische Schicht zwischen der positiven und der negativen Sammelschiene; ein Paar Gleichstromausgangsanschlüsse, die mit den Sammelschienen verbunden sind; und einen Kühlkörper, der unter den Sammelschienen positioniert ist und mit den Sammelschienen in Kontakt steht.

Der Erfindung liegt die technische Aufgabe zugrunde eine Leistungselektronikschaltung zu schaffen, die den Bauraum miniert und einen Schaltungsaufwand, insbesondere im Hinblick auf Hochspannungsschutz und Effizienz, verbessert.

Die Erfindung wird durch eine Leistungselektronikschaltung mit den Merkmalen des Patentanspruchs 1 erfindungsgemäß gelöst. Vorteilhafte Ausgestaltungen der Erfindung ergeben sich aus den Unteransprüchen.

Der Erfindung liegt die Idee zugrunde, Leistungselektronikmodule von einer Mehrzahl N von Funktionskomponenten, die auf einem Gleichspannungsniveau miteinander gekoppelt werden, alle in einen Zwischenkreis zu integrieren, der genau einen Zwischenkreiskondensator aufweist.

Insbesondere wird eine Leistungselektronikschaltung umfassend eine Mehrzahl N von Leistungselektronikmodulen von N Funktionskomponenten, wobei die Leistungselektronikmodule in einem Zwischenkreis energetisch auf einer Gleichspannungsebene miteinander gekoppelt sind, vorgeschlagen, wobei die Mehrzahl N von Leistungselektronikmodulen alle gemeinsam direkt an einen Zwischenkreiskondensator angeschlossen sind. Die Funktionskomponenten sind in sich abgeschlossene Funktionseinheiten. Es sind somit N verschiedene Funktionseinheiten, wobei N immer für eine natürliche Zahl größer 2 steht.

Hierdurch können die einzelnen Leistungselektronikmodule einfacher ausgebildet werden. Der Bauraum wird verringert. Die Leistungsverluste aufgrund von Induktivitäten von Leitungen können reduziert werden.

Bei einer bevorzugten Ausführungsform weist der Zwischenkreiskondensator zwei Kontaktierungselemente auf und weist jedes der Mehrzahl N von Leistungselektronikmodulen mindestens ein Paar von Anschlusselemente auf, wobei alle Paare von Anschlusselementen jeweils mit diesen zwei Kontaktierungselementen des Zwischenkreiskondensators verbunden sind. Hierdurch werden Leitungsverluste weiter minimiert.

Es wird angemerkt, dass ein Leistungselektronikmodul einer Wechselrichterschaltung zum Bereitstellen der verschiedenen Phasen für eine Bestromung einer elektrischen Maschine, beispielsweise eines Stators einer fremderregten Synchronmaschine (FSM), für jede Phase ein Paar von Anschlusselementen aufweist. Wird dreiphasiger Strom genutzt weist das Leistungselektronikmodul der Wechselrichterschaltung drei Paare von Anschlusselementen auf. Da diese jedoch gemeinsam eine Funktion erfüllen, stellen die Wechselrichterbrücken im Sinne der hier vorgeschlagenen Erfindung keine verschiedenen Funktionskomponenten oder Funktionseinheiten dar. Zwei gleichartige, jedoch redundante und nicht unmittelbar zusammenwirkende Funktionskomponenten, wie zwei Niedervolt-Gleichspanungs-Gleichspannungs-Wandler (DC/DC-Wandler) zum Betreiben von zwei getrennten Niedervolt - Bordnetzen, stellen verschiedene Funktionskomponenten im Sinne der Erfindung dar.

Bevorzugt sind die Kontaktierungselemente als Stromschienen ausgebildet. Diese werden auch als Sammelschienen bezeichnet. Die Stromschienen sind vorzugsweise als flache flächige Leiter ausgebildet, die jeweils lokal in einer Normalenrichtung senkrecht zu einer Oberfläche eine deutlich, in der Regel um mindestens eine Größenordnung, kleiner Ausdehnung als in den anderen beiden Raumrichtungen aufweist, die parallel zu der Oberfläche des flächigen Leiters orientiert sind und die Fläche des Leiters aufspannen und gemeinsam mit der Normalenrichtung ein dreidimensionales Koordinatensystem aufspannen.

Die flächige Leiter können Auskragungen und Vorsprünge aufweisen die jeweils in der Ebene ausgebildet sind, die mit der Ebene übereinstimmt, die der flächige Leiter an der Stelle der jeweiligen Auskragung/des jeweiligen Vorsprungs aufspannt.

Um eine Abschirmung im Hinblick auf einen Hochspannungsschutz zu erleichtern, sind bei einer bevorzugten Ausführungsform alle spannungsführenden Elemente des Zwischenkreis in einem Gehäuse gehaust.

Vorzugsweise umfasst das Gehäuse eine elektromagnetische Abschirmung. Eine elektromagnetische Verträglichkeit wird hierdurch deutlich verbessert.

Besonders bevorzugt sind eine Mehrheit der Mehrzahl N der Leistungselektronikmodule in das Gehäuse integriert sind, besonders bevorzugt sind die Mehrzahl N der Leistungselektronikmodule alle in das Gehäuse integriert.

Bei einer besonders bevorzugten Ausführungsform umschließt die elektromagnetische Abschirmung des Gehäuses die in das Gehäuse integrierten Leistungselektronikmodule. Hierdurch wird eine optimale Reduktion von elektromagnetischen Störungen erreicht. Zumindest zum Teil können so Leitungen zu den Funktionskomponenten verwendet werden, die keiner Schirmung bedürfen oder andere nachgelagerte Filter einfacher aufgebaut und ausgebildet werden.

Die einzelnen Leitungselektronikmodule können vereinfacht werden und weisen zwischen ihren Anschlusselementen ihres Paars oder ihrer Paare von Anschlusselementen keinen Kondensator auf (ausgenommen den Zwischenkreiskondensator).

Der der Zwischenkreis umfasst nur den einen Zwischenkreiskondensator. Dieser Zwischenkreiskondensator ist in einer Baueinheit ausgebildet ist, die bis auf die Kontaktierungselemente gegenüber anderen Bauteilen elektrisch getrennt ausgebildet ist.

So können die Leistungselektronikmodule von N Funktionskomponenten mit einem Zwischenkreiskondensator betrieben werden.

Ein solche Leistungselektronikschaltung kann sowohl mit geschirmten als auch ungeschirmten elektrischen Maschinen eingesetzt werden.

Nachfolgend wird die Erfindung unter Bezugnahme auf eine Zeichnung näher erläutert. Hierbei zeigt:

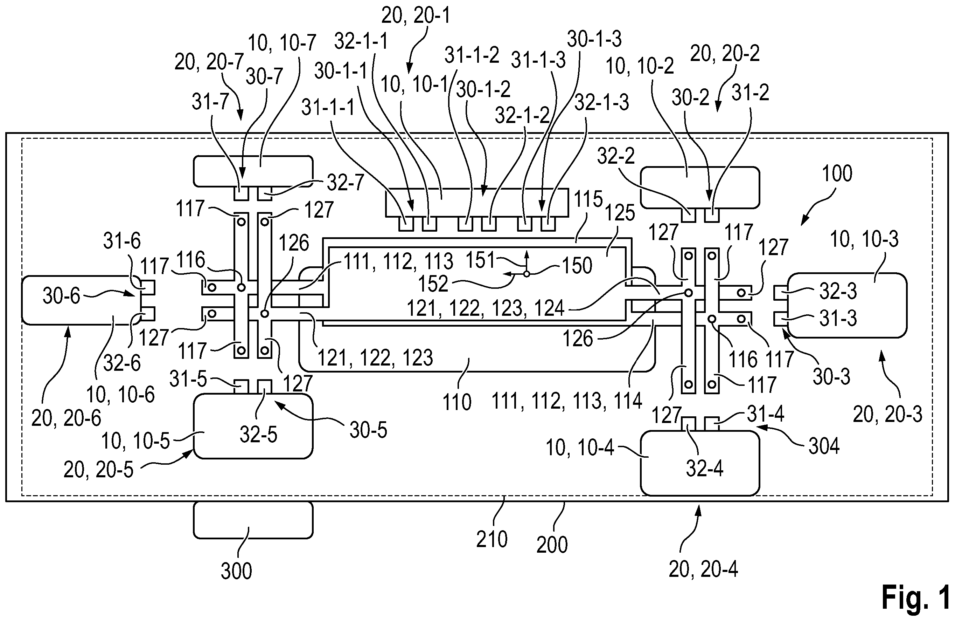

- Fig. 1: eine Leistungselektronikschaltung mit einer Mehrzahl N Leistungselektronikmodule von N Funktionskomponenten.

In Fig.1 ist eine Leistungselektronikschaltung 1 schematisch dargestellt. Die Leistungselektronikschaltung 1 umfasst eine Mehrzahl N Leistungselektronikmodule 10, 10-i. Die Leistungselektronikmodule 10, 10-i sind energetisch auf einem gemeinsamen Gleichspannungsniveau miteinander in einem Zwischenkreis 100 gekoppelt.

Die Nachstellung "-i" stellt einen Zählindex für die Leistungselektronikmodule und Funktionskomponenten dar.

Die Leistungselektronikmodule 10, 10-i umfassen die Leitungselektronik von einer Mehrzahl N verschiedener Funktionskomponenten 20, 20-i. Verschieden bedeutet in diesem Zusammenhang, dass die Funktionskomponenten schaltungstechnisch, abgesehen von ihrer Kopplung im gemeinsamen Zwischenkreis 100, und funktionell getrennt sind. In diesem Sinne sind zwei Niedervolt-Gleichspannung-Gleichspannung-Wandler verschiedene Funktionskomponenten, obwohl Sie gleichartig oder sogar identisch aufgebaut sind. Ein Wechselrichter zum Erzeugen einer mehrphasigen Wechselspannung stellt hingegen eine Funktionskomponente dar, obwohl die Brücken für die verschiedene Phasen jeweils individuell mit dem Zwischenkreis verbunden sind.

Um die energetische Kopplung auf einem Gleichspannungsniveau zu realisieren weist der Zwischenkreis 100 genau einen Zwischenkreiskondensator 110 auf. Dieser verfügt über zwei Pole 111, 121, die Kontaktierungselemente 112, 122 umfassen. Die Kontaktierungselemente 112,122 sind vorzugsweis als Stromschienen 113, 123 ausgebildet, die auch als Sammelschienen bezeichnet werden. Die Stromschienen 113, 123 sind vorzugsweis jeweils als flache flächige Leiter 114, 124 ausgebildet. Senkrecht zu der Fläche der flächigen Leiter 114, 124 weisen diese eine geringere Abmessung als entlang Raumrichtungen auf, die in der Fläche des flächigen Leiters liegen. Vorzugsweise ist die Abmessung entlang dieser Oberflächennormalen 150 in jedem Punkt um mehr als eine Größenordnung geringer als die Ausdehnungen entlang von Richtungen 151, 152 in der Ebene der flächigen Leiter 114, 124. Die Ebenen der beiden flächigen Leiter 114, 124 bzw. von flächig ausgebildeten Kontaktierungselementen 112, 122 sind vorzugsweise zumindest lokal an Stellen an denen sie einander überlappen (betrachtet entlang er Oberflächennormalen) jeweils parallel annähernd parallel zueinander ausgerichtet. Anstellen an denen sie einander nicht überlappen, sind diese vorzugsweise parallel nebeneinander geführt.

Die Kontaktierungselemente 112, 122 können Auskragungen 115, 125 und/oder Verzweigungen 116, 126 und/oder Vorsprünge 117, 127 aufweisen, die vorzugsweise als Anschlussstellen für Anschlusselemente 31, 32, 31-i, 32-i der Funktionskomponenten 20, 20-i dienen. Jede Funktionskomponenten weist somit mindestens ein Paar 30, 30-i von Anschlusselementen 31, 32, 31-i, 32-i auf. Zwischen den Anschlusselementen 31, 31-i, 32, 32-i eines Paars 30, 30-i ist in dem entsprechenden Leistungselektronikmodul 10, 10-i kein weiterer Kondensator ausgebildet, der eine Funktion einer energetischen Kopplung bewirkt. Die Leistungselektronikmodule 10, 10-i weisen somit zwischen den Anschlusselementen 31, 31-i, 32, 32-i ihres Paars 30, 30-i oder ihrer Paare 30-k, 30-i-k keinen Kondensator auf oder, falls doch, höchstens einen Kondensator für eine andere Funktionalität als die eines Zwischenkreiskondensators, z. B. für Filterzwecke, auf. Ein solcher Kondensator weist, falls überhaupt vorhanden, in der Regel eine Kapazität auf, die höchstens einem Zehntel (1/10), bevorzugter höchstens einem Hundertstel (1/100) noch bevorzugter höchstens einem Einhundertfünfzigstel (1/150) der Kapazität Zwischenkreiskondensators entspricht. Der nachgestellte Term "-k" stellt einen Zählindex für Anschlusspaare 30, 30-i einer Funktionskomponente i dar, wie beispielsweise bei Wechselrichterschaltungen zum Breitstellen des mehrphasigen Stroms für beispielsweise einen Stator einer elektrischen Maschine. Die Leistungselektronikmodule 10,10-i mit ihren Anschlusselementen 31, 32, 31-i, 32-i, 31-i-k, 32-i-k sind aus gründen der Übersichtlichkeit Beabstandet von dem Zwischenkreiskondensator 100 und dessen Kontaktierungselementen 112, 122 dargestellt.

Um eine elektrische Abschirmung zu erreichen ist die Leistungselektronikschaltung 1 vorzugsweis in eine Gehäuse 200 eingehaust. Besonders bevorzugt sind auch eine Vielzahl der Leistungselektronikmodule 10,10-i, vorzugsweise alle Leistungselektronikmodule 10,10-i, von dem Gehäuse 200 mit umschlossen.

Um eine gute elektromagnetische Verträglichkeit der Leistungselektronikschaltung 1 zu erreichen weist das Gehäuse vorzugsweise eine EMV-Abschirmung 210 auf.

Bei der dargestellten Ausführungsform sind beispielhaft in der Leistungselektronikschaltung 1 die Leistungselektronikmodule 10-1 bis 10-7 der Funktionskomponenten ausgebildet, die umfassen: einen Mehrphasenwechselrichter 20-1, einen Gleichspannungs-Wechselspannungs-Wandler 20-2 eines sogenannten integrierten Ladegeräts (engl. onboard charger), einen Niedervolt-Gleichspannungs-Gleichspannungswandler 20-3, einen Hochvolt-Gleichspannungs-Gleichspannungswandler 20-4, einen EMV-Filter 20-5 zum Anschließen einer Batterie 300, einen Klimakompressor 20-6, einen Filter-/Stromsteller 20-7 für einen Rotorstrom einer fremderregten Synchronmaschine.

Dargestellt ist lediglich eine exemplarische Ausführungsform.

### Bezugszeichenliste

- 1: Leistungselektronikschaltung
- 10, 10-i: Leistungselektronikmodule
- 20, 20-i: Funktionskomponente
- 20-1: Mehrphasenwechselrichter
- 20-2: Gleichspannungs-Wechselspannungs-Wandler
- 20-3: Niedervolt-Gleichspannungs-Gleichspannungswandler
- 20-4: Hochvolt-Gleichspannungs-Gleichspannungswandler
- 20-5: EMV-Filter
- 20-6: Klimakompressor
- 20-7: Filter-/Stromsteller (für FSM)
- 30, 30-i, 30-k, 30-i-k: Paar (Anschlusselemente)
- 31, 31-i, 31-i-k: Anschlusselement
- 32, 32-i, 32-i-k: Anschlusselement
- 100: Zwischenkreis
- 110: Zwischenkreiskondensator
- 111: Pol
- 112: Kontaktierungselement
- 113: Stromschiene
- 114: flächiger Leiter
- 115: Auskragung
- 116: Verzweigung
- 117: Vorsprung
- 121: Pol
- 122: Kontaktierungselement
- 123: Stromschiene
- 124: flächiger Leiter
- 125: Auskragung
- 126: Verzweigung
- 127: Vorsprung
- 150: Oberflächennormale
- 151: Richtung
- 152: Richtung
- 200: Gehäuse
- 210: (EMV-)Abschirmung
- 300: Batterie

## Patentansprüche

1. Leistungselektronikschaltung (1) umfassend eine Mehrzahl N von Leistungselektronikmodulen (10, 10-i) von N Funktionskomponenten, die in einem Zwischenkreis (100) energetisch auf einer Gleichspannungsebene miteinander gekoppelt sind, **dadurch gekennzeichnet, dass** die Mehrzahl N von Leistungselektronikmodulen (10, 10-i) alle gemeinsam direkt an einen Zwischenkreiskondensator (110) angeschlossen sind.

2. Leistungselektronikschaltung (1) nach Anspruch 1, **dadurch gekennzeichnet, dass** der Zwischenkreiskondensator (110) zwei Kontaktierungselemente (112, 122) aufweist und jedes der Mehrzahl N von Leistungselektronikmodulen (10, 10-i) mindestens ein Paar (30, 30-i, 30-i-k) Anschlusselemente (31, 31-i, 31-i-k, 32, 32-i, 32-i-k) aufweist, wobei alle Paare von Anschlusselementen (31, 31-i, 31-i-k, 32, 32-i, 32-i-k) jeweils mit diesen zwei Kontaktierungselementen (112, 122) des Zwischenkreiskondensators (110) verbunden sind.

3. Leistungselektronikschaltung (1) nach Anspruch 2, **dadurch gekennzeichnet, dass** die Kontaktierungselemente (112, 122) Stromschienen (113, 123) sind.

4. Leistungselektronikschaltung (1) nach einem der vorangehenden Ansprüche, **dadurch gekennzeichnet, dass** alle spannungsführenden Elemente des Zwischenkreis (100) in einem Gehäuse (200) gehaust sind.

5. Leistungselektronikschaltung (1) nach Anspruch 4, **dadurch gekennzeichnet, dass** das Gehäuse (200) eine elektromagnetische Abschirmung (210) umfasst.

6. Leistungselektronikschaltung (1) nach Anspruch 4 oder 5, **dadurch gekennzeichnet, dass** eine Mehrzeit der Mehrzahl N der Leistungselektronikmodule (10, 10-i) in das Gehäuse (200) integriert sind.

7. Leistungselektronikschaltung (1) nach Anspruch 6, **dadurch gekennzeichnet, dass** die Mehrzahl N der Leistungselektronikmodule (10, 10-i) alle in das Gehäuse (200) integriert sind.

8. Leistungselektronikschaltung (1) nach einem der Ansprüche 6 oder 7, **dadurch gekennzeichnet, dass** die elektromagnetische Abschirmung (210) des Gehäuses (200) die in das Gehäuse (200) integrierten Leistungselektronikmodule (10, 10-i) umschließt.

9. Leistungselektronikschaltung (1) nach einem der vorangehenden Ansprüche, **dadurch gekennzeichnet, dass** die Mehrzahl N der Leistungselektronikmodule (10, 10-i) jeweils zwischen ihren Anschlusselementen (31, 31-i, 31-i-k, 32, 32-i, 32-i-k) ihres Paars oder ihrer Paare von Anschlusselementen (31, 31-i, 31-i-k, 32, 32-i, 32-i-k) keinen Kondensator aufweisen.

10. Leistungselektronikschaltung (1) nach einem der vorangehenden Ansprüche, **dadurch gekennzeichnet, dass** der Zwischenkreis (100) nur den einen Zwischenkreiskondensator (110) umfasst. Und der Zwischenkreiskondensator (110) in einer Baueinheit ausgebildet ist.
